# EUROPÄISCHE PATENTSCHRIFT

(11) **EP 4 328 605 B1**
(45) Veröffentlichungstag und Bekanntmachung des Hinweises auf die Patenterteilung: **29.04.2026**
(21) Anmeldenummer: 23185029.8
(22) Anmeldetag: 12.07.2023
(51) Int. Cl.: H05K 1/02, F24H 9/20

(54) **VERFAHREN ZUM HERSTELLEN EINER STECKVERBINDUNG AUF EINER PLATINE EINES HEIZGERÄTES, STECKVERBINDUNG, REGEL- UND STEUERGERÄT, UND HEIZGERÄT**
METHOD FOR PRODUCING A PLUG-IN CONNECTION ON A PRINTED CIRCUIT BOARD OF A HEATING DEVICE, PLUG-IN CONNECTION, CONTROL AND DRIVE DEVICE, AND HEATING DEVICE
PROCÉDÉ DE FABRICATION D'UNE CONNEXION ENFICHABLE SUR UNE PLATINE D'UN APPAREIL DE CHAUFFAGE, CONNEXION ENFICHABLE, APPAREIL DE RÉGLAGE ET DE COMMANDE, ET APPAREIL DE CHAUFFAGE

(30) Priorität: 21.07.2022 DE 102022118327
(43) Veröffentlichungstag der Anmeldung: 28.02.2024
(73) Patentinhaber: Vaillant GmbH, 42859 Remscheid NRW (DE)
(72) Erfinder: Severin, Sascha, 44791 Boschum (DE)
(74) Vertreter: Popp, Carsten

(56) Entgegenhaltungen:
- WO-A2-2008/150523
- DE-A1- 102017 208 650
- US-A1- 2009 233 459
- US-A1- 2022 166 167
- US-A1- 2022 178 582

## Beschreibung

Die Erfindung betrifft ein Verfahren zum Herstellen einer Steckverbindung auf einer Platine eines Heizgerätes, eine Steckverbindung, ein Regel- und Steuergerät und ein Heizgerät.

Heizgeräte weisen in der Regel eine elektronische Steuerung und Regelung auf, die eine oder mehrere Platinen umfasst. Auf dieser sind Steckverbindungen für verschiedene Leitungen, beispielsweise für Steuersignale, Sensoren etc. vorgesehen. Die Steckverbindung umfasst dabei eine Wanne (auch als Buchse bezeichnet), die auf der Platine angeordnet ist/ wird und den elektrischen Kontakt mit Leitungen der Platine herstellt, sowie einen Stecker, der in die Wanne gesteckt wird und so eine elektrische Verbindung herstellen kann. Die Steckverbindungen sind für die Funktion des Heizgerätes elementar. Daher sind verschiedene Möglichkeiten bekannt, eine derartige Steckverbindung zu prüfen. Beispielsweise können Sensoren, die über die Steckverbindung elektrisch verbunden sind, angesteuert, und deren Signal auf Plausibilität überprüft werden. Hierbei kann jedoch ein defekter Sensor nicht von einem fehlenden Kontakt der Steckverbindung unterschieden werden.

Eine andere Möglichkeit besteht darin, im Stecker zwei Kontakte mittels einer Brücke (elektrisch) zu verbinden und nach einem Verbinden der Steckverbindung die elektrische Leitfähigkeit der Steckverbindung zur prüfen. Diese Möglichkeit ist aufwendig und erfordert zwei freie, ungenutzte Kontakte der Steckverbindung, wodurch zusätzliche Aufwand entsteht.

Nicht zuletzt kommen mechanische Verriegelungen von Steckverbindungen zum Einsatz, die jedoch keine Überprüfung der elektrischen Verbindung selbst ermöglichen. Beispielsweise wird in der DE 10 2017 208 650 A1 ein Rasthaken hierfür vorgeschlagen.

So wird in der DE 10 2017 213 147 A1 ein Verfahren zum Klassifizieren einer Steckverbindung vorgeschlagen, wobei eine von einem Monteur aufgebrachte Kraft bei der Montage der Steckverbindung erfasst und anschließend eine Mehrzahl von Merkmalen des Kraft-Zeit-Verlaufs bei der Montage der Steckverbindung ermittelt wird. Anschließend erfolgt eine Klassifizierung der Steckverbindung auf Basis der Mehrzahl von Merkmalen. Wie oben erwähnt, ermöglicht dieses Verfahren jedoch kein Überprüfen der elektrischen Kontaktierung der Steckverbindung.

Die US 2008/0261433 A1 hat ein System zur Überprüfung einer Steckverbindung zwischen einem ersten Kontaktglied und einem zweiten Kontaktglied zum Gegenstand, wobei zwei zusätzliche Kontakte von erstem und zweitem Kontaktglied, die beabstandet angeordnet sind, zur Überprüfung der elektrischen Kontaktierung genutzt werden. Nachteilig vergrößert dieses System die Steckverbindung und die zusätzlichen Kontakte erforderlichen bauliche Änderungen an der Steckverbindung.

Die WO 2008/150523 A2 beschreibt eine elektrische Steckverbindung, bei der zwei auf gegenüberliegenden Seiten und in einem äußeren Bereich des Steckers angeordnete Kontaktelemente durch ein in einer Wanne angeordnetes leitfähiges Band bzw. Leiter kurzgeschlossen werden, um so eine ordnungsgemäße elektrische Verbindung zu detektieren. Auch diese Lösung ist aufwendig und vergrößert das Gehäuse von Stecker bzw. Wanne.

Zudem können die vorgenannten Steckverbindungen ein Ablösen der Wanne von der Platine und/oder einen (dadurch begründeten) elektrischen Kontaktverlust von Stecker und Platine nicht detektieren.

Auch die US 2022 / 0166 167 A1 beschreibt eine elektrische Verbindung mit einem Detektionsmechanismus, der auf der der elektrischen Verbindung abgewandten Seite des Steckers angeordnet ist. Nachteilig erhöht ein derartiger Detektionsmechanismus die Bauraumanforderung für die elektrische Verbindung.

Die US 2009 / 0233 459 A1 beschreibt eine elektrische Steckverbindung mit Kontaktzungen, bei der zumindest zwei Kontaktzungen kürzer ausgebildet sind und so eine Einstecktiefe des Steckers in eine Wanne geprüft werden kann. Diese Lösung ist aufwendig und nicht ausreichend robust.

Hiervon ausgehend ist es Aufgabe der Erfindung, ein Verfahren zum Herstellen einer Steckverbindung auf einer Platine eines Heizgerätes, eine Steckverbindung, ein Regel- und Steuergerät und ein Heizgerät vorzuschlagen, die die geschilderten Probleme des Standes der Technik zumindest teilweise überwinden. Insbesondere soll die Erfindung eine einfache Möglichkeit zur Überprüfung der elektrischen Kontaktierung einer Steckverbindung eines Heizgerätes ermöglichen.

Zudem sollen das Verfahren bzw. die Steckverbindung einfach und kostengünstig herstellbar sein.

Diese Aufgaben werden gelöst durch die Merkmale der unabhängigen Patentansprüche. Weitere vorteilhafte Ausgestaltungen der hier vorgeschlagenen Lösung sind in den unabhängigen Patentansprüchen angegeben. Es wird darauf hingewiesen, dass die in den abhängigen Patentansprüchen aufgeführten Merkmale in beliebiger, technologisch sinnvoller, Weise miteinander kombiniert werden können und weitere Ausgestaltungen der Erfindung definieren. Darüber hinaus werden die in den Patentansprüchen angegebenen Merkmale in der Beschreibung näher präzisiert und erläutert, wobei weitere bevorzugte Ausgestaltungen der Erfindung dargestellt werden.

Hierzu trägt ein Verfahren zum Herstellen einer (elektrischen) Steckverbindung auf einer Platine eines Heizgerätes bei, welches zumindest die folgenden Schritte umfasst:
a) Einstecken eines Steckers der Steckverbindung in eine mit der Platine verbundenen Wanne der Steckverbindung;
b) Herstellen einer elektrischen Verifizierungskontaktierung außerhalb der Wanne zwischen Stecker und Platine,
c) Überprüfen der elektrischen Verifizierungskontaktierung zwischen Stecker und Platine.

Die Schritte a), b) und c) können bei einem regulären Verfahrensablauf mindestens einmal in der angegebenen Reihenfolge durchgeführt werden. Insbesondere kann der Schritt c) mehrmals wiederholt werden, beispielsweise bei jeder Inbetriebnahme des Heizgerätes. Zudem können die Schritte a) und b) häufig parallel (zeitgleich) durchgeführt werden. Das Verfahren dient der Überprüfung einer Steckverbindung, beispielsweise auf einer Platine eines Heizgerätes.

Das Heizgerät kann dazu eingerichtet sein, ein Gebäude mit Wärme für Heizung und Warmwasser zu versorgen. Hierzu kann das Heizgerät (mindestens) einen Wärmerzeuger umfassen, beispielsweise einen Gas-Brennwertkessel oder auch eine Wärmepumpe. Ein Heizgerät, eingerichtet zur Verbrennung eines Brennstoffes, kann die dabei freiwerdende Wärmeenergie über mindestens einen Wärmetauscher auf einen Heizkreis übertragen, wobei Verbraucher des Heizkreises über einen Heizungsvorlauf und einen Heizungsrücklauf an das Heizgerät anschließbar sind. Die bei der Verbrennung entstehenden Abgase können über einem Abgaskanal des Heizgerätes einer Abgasanlage zugeführt werden. Im Heizgerät kann im Heizkreislauf eine Umwälzpumpe dazu eingerichtet sein, ein Wärmeträgermedium (Heizungswasser) umzuwälzen, wobei über einen Heizungsvorlauf erwärmtes Wärmeträgermedium Verbrauchern, wie Konvektoren oder Flächenheizungen, zugeführt und über einen Heizungsrücklauf zum Wärmeerzeuger bzw. dem mindestens einen Wärmetauscher rückgeführt werden kann.

Hierzu kann das zur Verbrennung eingerichtete Heizgerät eine Fördereinrichtung, insbesondere ein Gebläse, aufweisen, das ein Gemisch aus Verbrennungsluft und Brennstoff einem Brenner des Heizgerätes zuführen kann.

Bei einem Heizgerät mit einer Wärmepumpe kann letztere eine beliebige Wärmepumpe sein, welche einen Kältekreislauf aufweist, in dem ein Kältemittel umgewälzt werden kann. Durch einen Phasenwechsel des Kältemittels in einem Verdampfer und einem Kondensator (Verflüssiger) des Kältekreislaufes kann ein Wärmetransport von einem Entnahmemedium, beispielsweise Erdboden, Umgebungsluft oder Grundwasser zu einem Abgabepunkt, häufig einem zu versorgenden Gebäude, bewirkt werden. Ein Verdichter und ein Expansionsventil können die notwendigen Druckunterschiede für den Phasenwechsel des Kältemittels erzeugen.

Durch den Verdichter im Kältekreislauf kann das gasförmige Kältemittel komprimiert und dessen Druck somit erhöht werden, wodurch gleichzeitig dessen Temperatur ansteigt. Im sich anschließenden Verflüssiger kann das gasförmige Kältemittel sich abkühlen und Wärme über einen mit dem Verflüssiger in Wirkverbindung stehenden Wärmetauscher beispielsweise in einen Heizkreislauf eines Gebäudes übertragen. Das nunmehr in flüssiger Phase vorliegende Kältemittel wird nun zu einem Expansionsventil (auch als Drossel bezeichnet) geführt und entspannt sich dort, wobei es sich dabei weiter abkühlt. In einem nachfolgenden Verdampfer kann das Kältemittel Wärme aus einem Umgebungsmedium (Umgebungsluft, Grundwasser oder Erdwärme) aufnehmen und sich erwärmen, bevor es erneut dem Verdichter zugeführt werden kann. Zur Aufrechterhaltung dieses Prozesses muss Energie durch den Verdichter zugeführt werden.

Ein hier vorgeschlagenes Verfahren kann insbesondere auf bzw. bei der Einrichtung einer Platine des Heizgerätes, beispielsweise auf einer Platine des Regel- und Steuergerätes, Anwendung finden.

Die Steckverbindung kann mindestens eine Wanne und mindestens einen Stecker umfassen. Die Wanne kann auf der Platine (unverlierbar) angeordnet und elektrisch mit dieser verbunden werden. Hierfür kann die Wanne so genannte Pins umfassen, die eine elektrische Verbindung durch Öffnungen der Platine herstellen und auf dieser verlötet sein können.

Der Stecker kann mit mindestens einem Kabel verbindbar sein und in die Wanne (bevorzugt nur in einer vordefinierten Relativlage) eingesteckt werden, wobei eine elektrische Verbindung von einem mit dem Stecker verbundenen, Kabel mit den Pins der Wanne und damit mit den den Pins zugeordneten Leitungsbahnen der Platine.

Nach dem Stand der Technik können, um die elektrische Verbindung von Stecker und Wanne zu prüfen, im Stecker zwei Kontakte überbrückt, also elektrisch verbunden werden. Dabei kann nun ein Stromfluss über diese überbrückten Kontakte des Steckers fließen, und - sofern dieser festgestellt wird - von einer ordnungsgemäßen Steckverbindung ausgegangen werden. Wie bereits ausgeführt müssen für eine derartige Überprüfung zusätzliche Pins an der Wanne vorgesehen werden und zum Stecker geführt werden, wodurch zusätzlicher Aufwand entsteht und zudem die Baugröße von Stecker und Wanne vergrößert werden muss.

Gemäß Schritt a) kann ein Einstecken eines Steckers der Steckverbindung in eine mit der Platine verbundene Wanne der Steckverbindung erfolgen. Mit anderen Worten wird somit die mechanische und elektrische Verbindung zwischen Stecker und Wanne und somit eine elektrische Verbindung zwischen dem mit dem Stecker verbundenen Kabel und den elektrischen Leitungsbahnen der Platine, (die mit der Wanne elektrisch verbunden sind) hergestellt. Nach dem Einstecken des Steckers in die Wanne kann, sofern vorhanden, eine mechanische Verriegelung des Steckers in der Wanne, beispielsweise durch eine Clipverbindung, einrasten und so ein ungewolltes (beispielsweise aufgrund von Vibrationen des Heizgerätes) Lösen der Steckverbindung verhindern.

Gemäß Schritt b) kann ein Herstellen einer elektrischen Verifizierungskontaktierung zwischen Stecker und Platine, erfolgen. Insbesondere kann der Schritt b) unmittelbar anschließend bzw. sogar (zumindest teilweise) parallel zu Schritt a) ausgeführt werden, also die elektrische Verifizierungskontaktierung zwischen Stecker und Platine im Rahmen der Durchführung des Schrittes a), also ausgelöst durch das Einstecken des Steckers in die Wanne, hergestellt werden.

Die elektrische Verifizierungskontaktierung zwischen Stecker und Platine kann dabei eine (elektrische) Kontaktierung sein, die durch den Stecker (mittelbar oder unmittelbar) auf der Platine geschlossen wird und somit ein ordnungsgemäßes Einstecken des Steckers in die Wanne anzeigt. Die elektrische Verifizierungskontaktierung zwischen Stecker und Platine erfolgt von außerhalb der Wanne, also z.B. in der Nachbarschaft der Wanne und/oder unterhalb der Wanne. Die elektrische Verifizierungskontaktierung erstreckt sich insbesondere bis außerhalb der Wanne und/oder ist (teilweise) an einer Außenfläche der Wanne bzw. an der Wanne von außen zugänglich angeordnet. Es ist möglich, dass die Platine und/oder die Wanne mit einem (zusätzlichen bzw. nur zu diesem Zweck eingerichteten) elektrischen Verifizierungskontakt ausgebildet ist, der mittels bzw. über den Stecker (aber nicht dessen Pins) geschlossen werden kann.

Für die elektrische Verifizierungskontaktierung kann der Stecker ein Verifizierungskontaktelement umfassen, das dazu eingerichtet sein kann, einen Verifizierungskontaktbereich der Platine beim Einstecken des Steckers in die Wanne zu kontaktieren, wobei durch Verifikation eines Stromflusses über die Verifizierungskontaktierung eine ordnungsgemäße Steckverbindung feststellbar sein kann. Es ist möglich, dass das Verifizierungskontaktelement des Steckers durch die Wanne geführt ist bzw. wird, um eine Verifizierungskontaktierung auf der Platine zu schließen. Es ist (alternativ oder kumulativ) möglich, dass ein (elektrischer) Verifizierungskontaktbereich in einem (mechanischen) Kontaktbereich zwischen Stecker und Wanne angeordnet ist bzw. wird. Hierzu kann die Wanne Mittel umfassen, um von entsprechenden Leiterbahnen auf der Platine eine elektrische Kontaktierung zu dem Verifizierungskontaktbereich im Kontaktbereich zwischen Stecker und Wanne herzustellen.

Insbesondere können somit die Schritte a) und b) (zeitlich) parallel bzw. zusammenhängend durchgeführt werden, wobei bei dem Einstecken des Steckers in die Wanne gleichzeitig die Verifizierungskontaktierung hergestellt werden kann, insbesondere durch ein in Kontakt bringen des Verifizierungskontaktbereichs der Platine mit dem Verifizierungskontaktelement es Steckers.

Gemäß Schritt c) kann ein Überprüfen der elektrischen Verifizierungskontaktierung zwischen Stecker und Platine erfolgen. Hierzu kann in der Regel ein elektrischer Stromfluss über die Verifizierungskontaktierung geprüft werden, also eine Spannung an die Verifizierungskontaktierung angelegt werden und ein (vorbestimmter) Stromfluss festgestellt werden. Eine Durchführung des Schrittes c) kann (unmittelbar) im Anschluss an eine Durchführung der Schritte a) und b) erfolgen, aber auch (zu vorgebbaren Zeitpunkten und/oder regelmäßig) wiederholt werden, beispielsweise bei jeder Inbetriebnahme (vor jedem Zündvorgang) des Heizgerätes. So kann auch ein Lösen der Steckverbindung durch (Betriebs-)Vibrationen des Heizgerätes oder auch nach anderen mechanischen Einwirkungen, wie einem Zündrückschlag, festgestellt werden.

Somit wird mittels eines hier vorgeschlagenen Verfahrens eine Steckverbindung geschaffen, die einen gesonderten Verifizierungskontakt im Bereich der Schnittstelle zwischen Platine und Wanne und/ oder zwischen Wanne und Stecker ausbildet und so keinen zusätzlichen Bauraum für die Ausbildung des Verifizierungskontaktes beansprucht. Dabei ist der Verifizierungskontaktierung kein Kontakt des Steckers und insbesondere kein Kabel am Stecker zugeordnet. Die Verifizierungskontaktierung kann insbesondere zwei Leiter umfassen, die im Bereich der Wanne oder der Platine durch das Montieren des Steckers in der Wanne elektrisch verbunden werden.

Gemäß einer Ausgestaltung kann bei der Durchführung von Schritt b) ein offener bzw. unterbrochener (elektrischer) Schaltkontakt auf der Platine durch den in die Wanne eingeführten Stecker elektrisch geschlossen werden. Der Schaltkontakt kann zwei Kontaktbereiche von zwei elektrischen Leitern umfassen, die durch den Stecker mechanisch miteinander verbunden werden. Hierzu können die beiden elektrischen Leiter derart in unmittelbarer Nähe zueinander angeordnet sein, dass durch ein Einstecken des Steckers mit einer vorgegebenen Einsteckposition in der Wanne, die beiden elektrischen Leiter kontaktiert werden und die Verifizierungskontaktierung somit geschlossen wird.

Gemäß einer Ausgestaltung kann der Verifizierungskontaktbereich als zwei benachbart angeordnete Kontaktbereiche zweier Leiter ausgebildet sein, die durch das Verifizierungskontaktelement, das hierbei als elektrisch leitfähiger, flächiger Bereich ausgebildet sein, kann, beim Einstecken des Steckers in die Wanne gemäß Schritt a) zur Durchführung des Schrittes b) elektrisch leitend verbunden werden. Hierbei können die Kontaktbereiche des Verifizierungskontaktbereiches auf einer dem Stecker zugewandten Seite der Wanne und das Verifizierungskontaktelement auf einer der Wanne zugewandten Seite des Steckers angeordnet sein.

Gemäß einer Ausgestaltung kann im Rahmen der Durchführung von Schritt b) ein Verifizierungskontaktelement des Steckers einen elektrischen Kontakt zwischen Oberseite und Unterseite der Platine herstellen. Mit anderen Worten kann hierfür der Verifizierungskontaktbereich als zwei Leiterenden ausgebildet sein, die gegenüberliegend auf unterschiedlichen Seiten der Platine angeordnet und durch eine Bohrung verbunden sind, und das Verifizierungskontaktelement durch diese Bohrung die beiden Leiterenden elektrisch verbindet. Das Verifizierungskontaktelement kann hierfür beispielsweise ein Pin (Kontaktfuß) sein.

Nach einem weiteren Aspekt wird auch eine Steckverbindung vorgeschlagen, zumindest umfassend einen Stecker und eine mit einer Platine zu verbindende bzw. verbundene Wanne, welche eingerichtet zur (passgenauen) Aufnahme des Steckers ist, wobei der Stecker dazu eingerichtet ist, in der eingesteckten Position eine (separate) elektrische Verifizierungskontaktierung außerhalb der Wanne zwischen Stecker und Platine herzustellen.

Gemäß einer Ausgestaltung kann der Stecker ein (separates, neben den üblichen Pins vorgesehenes) Verifizierungskontaktelement umfassen, das die Verifizierungskontaktierung herstellt.

Gemäß einer Ausgestaltung kann das Verifizierungskontaktelement und/ oder der Verifizierungskontaktbereich dazu eingerichtet sein, im eingesteckten Zustand der Steckverbindung durch eine Öffnung in (dem Boden) der Wanne einen Kontakt mit dem Verifizierungskontaktbereich bzw. dem Verifizierungskontaktelement der Platine herzustellen.

Nach einem weiteren Aspekt wird auch ein Regel- und Steuergerät für ein Heizgerät vorgeschlagen, aufweisend mindestens eine hier vorgeschlagene Steckverbindung.

Nach einem weiteren Aspekt wird auch ein Heizgerät vorgeschlagen, insbesondere eingerichtet, ein Gebäude mit Wärme für Heizung und Warmwasser zu versorgen, wobei dieses ein hier vorgeschlagenes Regel- und Steuergerät und/ oder eine hier vorgeschlagene Steckverbindung aufweist. Bei dem Heizgerät kann es sich um ein Gasheizgerät, insbesondere um ein wasserstoffbetriebenes Gasheizgerät, oder auch ein Heizgerät umfassend eine Wärmepumpe handeln. Das Gasheizgerät kann einen Brenner und eine Fördereinrichtung aufweisen, mit der ein Gemisch aus Verbrennungsgas (Wasserstoff) und Verbrennungsluft dem Brenner zugeführt werden kann.

Die im Zusammenhang mit dem Verfahren erörterten Details, Merkmale und vorteilhaften Ausgestaltungen können entsprechend auch bei der hier vorgestellten Steckverbindung, dem Regel- und Steuergerät und dem Heizgerät auftreten und umgekehrt. Insoweit wird auf die dortigen Ausführungen zur näheren Charakterisierung der Merkmale vollumfänglich Bezug genommen.

Hier werden somit ein Verfahren zum Herstellen einer Steckverbindung auf einer Platine eines Heizgerätes, eine Steckverbindung, ein Regel- und Steuergerät und ein Heizgerät angegeben, welche die mit Bezug auf den Stand der Technik geschilderten Probleme zumindest teilweise lösen. Insbesondere tragen das Verfahren zum Herstellen einer Steckverbindung auf einer Platine eines Heizgerätes, die Steckverbindung, das Regel- und Steuergerät und das Heizgerät zumindest dazu bei, eine einfache Verifizierung des Kontaktes einer Steckverbindung zu ermöglichen. Dabei kann zudem die Baugröße von Stecker und Wanne gegenüber Lösungen nach dem Stand der Technik verringert werden.

Die Erfindung sowie das technische Umfeld werden nachfolgend anhand der beiliegenden Figuren näher erläutert. Es ist darauf hinzuweisen, dass die Erfindung durch die angeführten Ausführungsbeispiele nicht beschränkt werden soll. Insbesondere ist es, soweit nicht explizit anders dargestellt, auch möglich, Teilaspekte der in den Figuren erläuterten Sachverhalte zu extrahieren und mit anderen Bestandteilen und Erkenntnissen aus der vorliegenden Beschreibung zu kombinieren. Insbesondere ist darauf hinzuweisen, dass die Figuren und insbesondere die dargestellten Größenverhältnisse nur schematisch sind. Es zeigen:
- Fig. 1:: ein hier vorgeschlagenes Heizgerät, und
- Fig. 2 bis 4:: verschiedene Ausgestaltungen der Verifizierungskontaktierung.

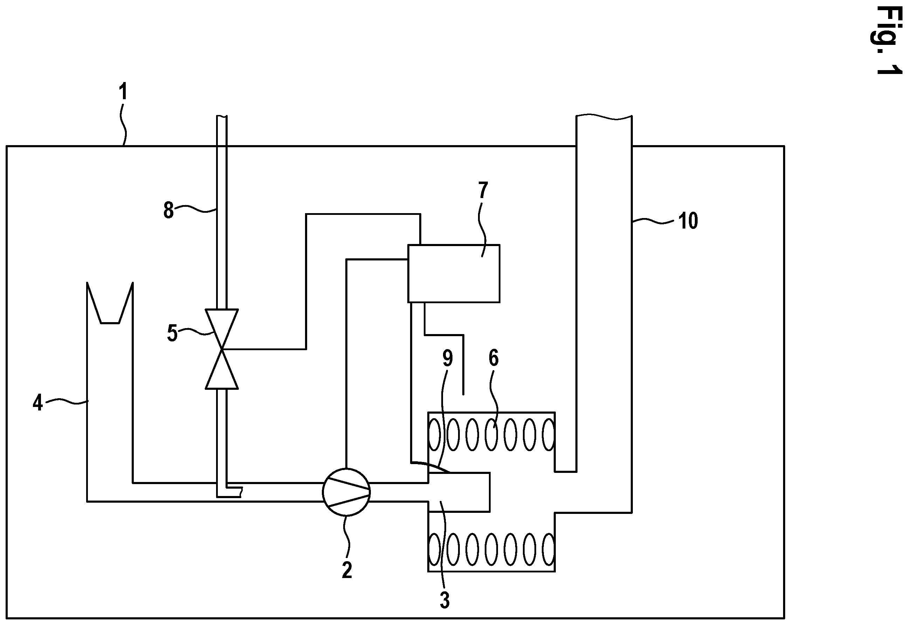

Fig. 1 zeigt beispielhaft und schematisch ein hier vorgeschlagenes Heizgerät 1. Dieses kann über eine Fördereinrichtung 2 Luft von einer Zuführung Verbrennungsluft 4 ansaugen und zu einem Brenner 3 befördern. Über ein Gasventil 5 kann ein Brenngas, beispielsweise Wasserstoff oder ein wasserstoffhaltiges Gemisch, aus einer Zuführung Brenngas 8 der Verbrennungsluft beigemischt werden. Das entstehende Brenngas-Luft-Gemisch kann mittels einer Zündelektrode 9 am Brenner 3 gezündet und verbrannt werden. Entstehende Abgase geben den größten Teil ihrer Wärme an einen Wärmetauscher 6 ab und können dann durch ein Abgasrohr 10 des Heizgeräts 1 einer, dem Heizgerät 1 nachgelagerten, Abgasanlage in die Umgebung abgeführt werden. Ein Regel- und Steuergerät 7 kann dazu eingerichtet sein, Betriebsvorgänge des Heizgerätes 1 zu regeln bzw. zu steuern.

Beispielsweise das Regel- und Steuergerät 7 kann mindestens eine hier vorgeschlagene Steckverbindung 11 umfassen.

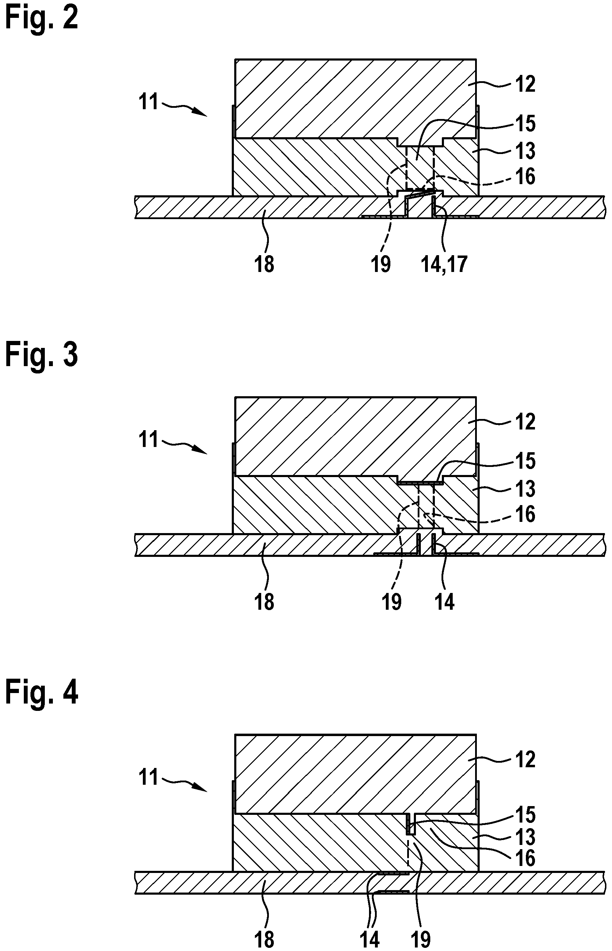

Die Fig. 2 bis 4 zeigen beispielhaft und schematisch verschiedene Ausgestaltung einer hier vorgeschlagenen Steckverbindung 11, hergestellt nach einem hier vorgestellten Verfahren.

Fig. 2 zeigt beispielhaft und schematisch eine Steckverbindung 11 umfassend einen Stecker 12 und eine Wanne 13, wobei die Wanne 13 auf einer Platine 18 angeordnet ist und Pins der Wanne 13 mit Leiterbahnen der Platine elektrisch kontaktierend verbunden sein können. Ein Verifizierungskontaktbereich 14 der Wanne 13 kann als Schaltkontakt 17 ausgebildet und auf der Platine 18 angeordnet sein. Beim Einstecken des Steckers 12 in die Wanne 13 kann ein Verifizierungskontaktelement 15 durch eine Öffnung in der Wanne 13 auf den Schaltkontakt 17 Druck ausüben und diesen damit schließen und somit eine Verifizierungskontaktierung 16 des Schaltkontaktes 17 herstellen, der zur Verifikation der Steckverbindung 11 nutzbar sein kann.

Fig. 3 zeigt gleichfalls beispielhaft und schematisch eine weitere Ausgestaltung einer Steckverbindung 11, bei der auf der Platine 18 ein Verifizierungskontaktbereich 14 in Form eines zweier benachbart angeordneter Kontakte ausgebildet sein kann, wobei beide Kontakte des Verifizierungskontaktbereiches 14 durch eine Öffnung 19 in der Wanne 13 geführt werden. Im eingesteckten Zustand des Steckers 12 kann dessen Verifizierungskontaktelement 15, hier ausgebildet als ein flächiger, leitender Bereich an der, der Wanne 13 zugewandten, Seite des Steckers 12. Das Verifizierungskontaktelement 15 kann so eine elektrische Verbindung der beiden Kontakte des Verifizierungskontaktbereiches 14 herstellen und so die Verifizierungskontaktierung 16 schließen.

Fig. 4 zeigt ebenfalls beispielhaft und schematisch eine weitere Ausgestaltung einer Steckverbindung 11, bei der der Verifizierungskontaktbereich 14 durch zwei Kontakte gebildet werden kann, die jeweils auf der Oberseite und Unterseite der Platine 18 angeordnet und durch eine Bohrung verbunden sein können. Das Verifizierungskontaktelement 15 kann hier als Pin oder ähnliches ausgebildet sein, die durch eine Öffnung 19 der Wanne 13 und die Bohrung in der Platine 18 die Verifizierungskontaktierung 16 durch elektrisches Verbinden der beiden auf der Oberseite und Unterseite der Platine 18 angeordneten Kontakte des Verifizierungskontaktbereiches 14 schließen kann.

Die Ausgestaltungen gemäß Fig. 2 - 4 zeigen somit Verifizierungskontaktierungen 16, die mittels Durchführung der Schritte a) und b) eines hier vorgeschlagenen Verfahrens gebildet wurden.

Gemäß einem Schritt c) kann nun ein Überprüfen der elektrischen Verifizierungskontaktierung 16 zwischen Stecker 12 und Platine 18 erfolgen. Hierzu kann eine Spannung an die Verifizierungskontaktierung 16 angelegt werden und der resultierende Stromfluss erfasst/ geprüft werden.

### Bezugszeichenliste

- 1: Heizgerät
- 2: Fördereinrichtung
- 3: Brenner
- 4: Zuführung Verbrennungsluft
- 5: Gasventil
- 6: Wärmetauscher
- 7: Regel- und Steuergerät
- 8: Zuführung Brenngas
- 9: Zündelektrode
- 10: Abgasrohr
- 11: Steckverbindung
- 12: Stecker
- 13: Wanne
- 14: Verifizierungskontaktbereich
- 15: Verifizierungskontaktelement
- 16: Verifizierungskontaktierung
- 17: Schaltkontakt
- 18: Platine
- 19: Öffnung

## Patentansprüche

1. Verfahren zum Herstellen einer Steckverbindung (11) auf einer Platine (18) eines Heizgerätes (1), umfassend zumindest die folgenden Schritte:
a) Einstecken eines Steckers (12) der Steckverbindung (11) in eine mit der Platine (18) verbundenen Wanne (13) der Steckverbindung (11);
b) Herstellen einer elektrischen Verifizierungskontaktierung (16) außerhalb der Wanne (13) zwischen Stecker (12) und Platine (18) und ,
c) Überprüfen der elektrischen Verifizierungskontaktierung (16) zwischen Stecker (12) und Platine (18).

2. Verfahren nach Anspruch 1, wobei im Rahmen der Durchführung von Schritt b) ein offener Schaltkontakt (17) auf der Platine (18) durch ein Verifizierungskontaktelement (15) des Steckers (12) elektrisch geschlossen wird.

3. Verfahren nach Anspruch 1, wobei im Rahmen der Durchführung des Schrittes b) ein Verifizierungskontaktbereich (14) als zwei benachbart angeordnete Kontaktbereiche zweier Leiter ausgebildet ist, die durch das, als elektrisch leitfähiger, flächiger Bereich, ausgebildete Verifizierungskontaktelement (15) elektrisch verbunden werden.

4. Verfahren nach Anspruch 1, wobei im Rahmen der Durchführung von Schritt b) ein Verifizierungskontaktelement (15) des Steckers einen elektrischen Kontakt zwischen zwei, den Verifizierungskontaktbereich (14) bildenden Kontakten, angeordnet jeweils an einer Oberseite und einer Unterseite der Platine (18), herstellt.

5. Verfahren nach einem der vorangehenden Ansprüche, wobei eine Durchführung des Schrittes c) regelmäßig wiederholt wird.

6. Steckverbindung (11) zur Durchführung eines Verfahrens nach einem der vorangehenden Ansprüche, zumindest umfassend einen Stecker (12) und eine mit einer Platine (18) verbindbare Wanne (13), eingerichtet zur Aufnahme des Steckers (12), wobei der Stecker (12) dazu eingerichtet ist, eine elektrische Verifizierungskontaktierung (16) außerhalb der Wanne (12) zwischen Stecker (12) und Platine (18) herzustellen.

7. Steckverbindung (11) nach Anspruch 6, wobei der Stecker ein Verifizierungskontaktelement (15) umfasst, das die Verifizierungskontaktierung (16) mit einem Verifizierungskontaktbereich (14) der Platine (18) herstellt

8. Steckverbindung (11) nach Anspruch 6 oder 7, wobei das Verifizierungskontaktelement (15) dazu eingerichtet ist, im verbundenen Zustand der Steckverbindung (11) durch eine Öffnung (19) in der Wanne (13) einen Kontakt mit dem Verifizierungskontaktbereich (14) der Platine (18) herzustellen.

9. Regel- und Steuergerät (7) für ein Heizgerät (1), aufweisend mindestens eine Steckverbindung (11) nach einem der Ansprüche 6 bis 8.

10. Heizgerät (1), aufweisend mindestens eine Steckverbindung (11) nach einem der Ansprüche 6 oder 7 und/ oder ein Regel- und Steuergerät (7) nach Anspruch 9.

## Claims

1. Method for producing a plug connection (11) on a circuit board (18) of a heating device (1), comprising at least the following steps:
a) inserting a plug (12) of the plug connection (11) into a tray (13) of the plug connection (11) connected to the circuit board (18);
b) Establishing an electrical verification contact (16) outside the tray (13) between the plug (12) and the circuit board (18); and
c) Checking the electrical verification contact (16) between the plug (12) and the circuit board (18).

2. Method according to claim 1, wherein, during the execution of step b), an open switch contact (17) on the circuit board (18) is electrically closed by a verification contact element (15) of the plug (12).

3. Method according to claim 1, wherein, as part of the execution of step b), a verification contact area (14) is designed as two adjacent contact areas of two conductors, which are electrically connected by the verification contact element (15) designed as an electrically conductive, flat area.

4. Method according to claim 1, wherein, in the course of performing step b), a verification contact element (15) of the plug establishes electrical contact between two contacts forming the verification contact area (14), arranged respectively on an upper side and a lower side of the circuit board (18).

5. Method according to one of the preceding claims, wherein step c) is repeated regularly.

6. Plug connection (11) for carrying out a method according to one of the preceding claims, comprising at least a plug (12) and a tray (13) connectable to a circuit board (18), designed to accommodate the plug (12), wherein the plug (12) is designed to establish an electrical verification contact (16) outside the tray (12) between the plug (12) and the circuit board (18) .

7. Plug connection (11) according to claim 6, wherein the plug comprises a verification contact element (15) which establishes the verification contact (16) with a verification contact area (14) of the circuit board (18)

8. Plug connection (11) according to claim 6 or 7, wherein the verification contact element (15) is designed to establish contact with the verification contact area (14) of the circuit board (18) through an opening (19) in the tray (13) when the plug connection (11) is in the connected state.

9. Control and regulating device (7) for a heating device (1), comprising at least one plug connection (11) according to one of claims 6 to 8.

10. Heating device (1) comprising at least one plug connection (11) according to one of claims 6 or 7 and/or a control and regulation device (7) according to claim 9.

## Revendications

1. Procédé de fabrication d'une connexion enfichable (11) sur une platine (18) d'un appareil de chauffage (1), comprenant au moins les étapes suivantes :
a) enfichage d'une fiche (12) de la connexion enfichable (11) dans un carter (13) de la connexion (11) connecté à la platine (18) ;
b) réalisation d'une mise en contact de vérification électrique (16) à l'extérieur du carter (13) entre la fiche (12) et la platine (18) et,
c) vérification de la mise en contact de vérification électrique (16) entre la fiche (12) et la platine (18).

2. Procédé selon la revendication 1, dans lequel, dans le cadre de la réalisation de l'étape b), un contact de commutation ouvert (17) sur la platine (18) est fermé électriquement par un élément de contact de vérification (15) de la fiche (12).

3. Procédé selon la revendication 1, dans lequel, dans le cadre de la réalisation de l'étape b), une zone de contact de vérification (14) est formée comme deux zones de contact disposées de manière adjacente de deux conducteurs qui sont connectés électriquement par l'intermédiaire de l'élément de contact de vérification (15) formé en tant que zone plane électriquement conductrice.

4. Procédé selon la revendication 1, dans lequel, dans le cadre de la réalisation de l'étape b), un élément de contact de vérification (15) de la fiche établit un contact électrique entre deux contacts formant la zone de contact de vérification (14), disposés respectivement sur un côté supérieur et un côté inférieur de la platine (18).

5. Procédé selon l'une quelconque des revendications précédentes, dans lequel une réalisation de l'étape c) est régulièrement répétée.

6. Connexion enfichable (11) pour la réalisation d'un procédé selon l'une quelconque des revendications précédentes, comprenant au moins une fiche (12) et un carter (13) pouvant être connecté à une platine (18), configurée pour loger la fiche (12), dans laquelle la fiche (12) est configurée pour établir une mise en contact de vérification électrique (16) à l'extérieur du carter (12) entre la fiche (12) et la platine (18).

7. Connexion enfichable (11) selon la revendication 6, dans laquelle la fiche comprend un élément de contact de vérification (15) qui établit la mise en contact de vérification (16) avec une zone de contact de vérification (14) de la platine (18).

8. Connexion enfichable (11) selon la revendication 6 ou 7, dans lequel l'élément de contact de vérification (15) est configuré pour établir, à l'état connecté de la connexion enfichable (11), un contact avec la zone de contact de vérification (14) de la platine (18) à travers une ouverture (19) dans le carter (13).

9. Appareil de régulation et de commande (7) pour un appareil de chauffage (1), présentant au moins une connexion enfichable (11) selon l'une quelconque des revendications 6 à 8.

10. Appareil de chauffage (1) présentant au moins une connexion enfichable (11) selon l'une quelconque des revendications 6 ou 7 et/ou un appareil de régulation et de commande (7) selon la revendication 9.
